(19) Europäisches Patentamt
European Patent Office
Office européen des brevets

(11) Veröffentlichungsnummer: **0 010 749**
**B1**

(12) # EUROPÄISCHE PATENTSCHRIFT

(45) Veröffentlichungstag der Patentschrift: **22.12.82**

(51) Int. Cl.³: **G 03 F 7/08**

(21) Anmeldenummer: **79104171.8**

(22) Anmeldetag: **29.10.79**

(54) **Lichtempfindliches Gemisch und daraus hergestelltes Kopiermaterial.**

(30) Priorität: **04.11.78 DE 2847878**

(43) Veröffentlichungstag der Anmeldung: **14.05.80 Patentblatt 80/10**

(45) Bekanntmachung des Hinweises auf die Patenterteilung: **22.12.82 Patentblatt 82/51**

(84) Benannte Vertragsstaaten: **AT BE CH DE FR GB IT NL SE**

(56) Entgegenhaltungen:
**DE-A-2 146 167**
**DE-A-2 547 905**
**FR-A-1 418 019**

**CHEMICAL ABSTRACTS, Vol. 77, Nr. 14, Oktober 1972, Seite 509, Nr. 95380a Columbus, Ohio, U.S.A.**

(73) Patentinhaber: **HOECHST AKTIENGESELLSCHAFT, Postfach 80 03 20, D-6230 Frankfurt/Main 80 (DE)**

(72) Erfinder: **Stahlhofen, Paul, Dr., Walter-Gieseking-Strasse 28, D-6200 Wiesbaden (DE)**

**EP 0 010 749 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Lichtempfindliches Gemisch und daraus hergestelltes Kopiermaterial

Die Erfindung betrifft ein positiv arbeitendes lichtempfindliches Gemisch, das für die Herstellung von lithographischen Druckplatten, Kopierlacken u.dgl. geeignet ist.

Lichtempfindliche Gemische bzw. Kopiermaterialien dieser Gattung, deren bildmässig belichtete Bereiche in einer Entwicklerlösung löslich werden, in der die unbelichteten Bereiche unlöslich sind, sind seit langem bekannt. Für die Herstellung derartiger Materialien werden in der Praxis vor allem Schichten mit o-Chinondiaziden als lichtempfindliche Verbindungen verwendet, die noch Harze mit alkalilöslich machenden Gruppen enthalten, z.B. Phenolharze.

Derartige Kopierschichten haben jedoch eine relativ schlechte Lichtempfindlichkeit. In der Vergangenheit wurden daher bereits verschiedene Vorschläge zur Verbesserung der photographischen Empfindlichkeit derartiger strahlungsempfindlicher Kopiermaterialien aus einer o-Naphthochinondiazidverbindung und einem alkalilöslichen, filmbildenden Phenolharz gemacht. Derartige Versuche führten bisher jedoch noch nicht zu einem bemerkenswerten Erfolg. So erhöht zwar eine Verringerung des Mengenanteils an o-Naphthochinondiazidverbindung in der Kopierschicht bemerkenswert die Lichtempfindlichkeit, jedoch führt eine derartige Veränderung zu mangelhafter Entwicklerresistenz der Kopierschicht.

Die Empfindlichkeit von o-Naphthochinondiazidschichten gegenüber Elektronenstrahlung kann, wie in der US-PS 3 661 582 beschrieben, durch Zusatz bestimmter N-Heterocyclen, wie 2-Azacyclononan-2-on, Indol, Chinazolin und Tetrazol, erhöht werden. Auch diese Systeme haben nur eine äusserst enge Entwicklungsbreite ähnlich wie im oben geschilderten Fall.

In der japanischen Patentanmeldung 42 449/1971 sind verschiedene Zusätze, z.B. Triphenylmethanfarbstoffe, Benzaldehyd-m-tolylhydrazon, halogenierte Kohlenwasserstoffe und Azofarbstoffe beschrieben, um die photographische Empfindlichkeit zu erhöhen; keine dieser Verbindungen hat jedoch eine bemerkenswerte Wirksamkeit.

In der DE-OS 2 657 922 wird schliesslich der Zusatz von cyclischen Säureanhydriden für den gleichen Zweck beschrieben. Auch hier wird eine deutliche Erhöhung der Empfindlichkeit nur auf Kosten der Entwicklerresistenz erreicht.

Der vorliegenden Erfindung liegt deshalb die Aufgabe zugrunde, die Lichtempfindlichkeit eines lichtempfindlichen Gemisches, das eine o-Naphthochinondiazidverbindung und ein alkalilösliches Phenolharz enthält, zu verbessern, ohne dass andere wesentliche Eigenschaften hierbei nachteilig beeinflusst werden.

Die Erfindung geht aus von einem lichtempfindlichen Gemisch, das

a) als lichtempfindliche Verbindung einen Ester oder ein Amid einer 1,2-Naphthochinondiazidsulfon- oder -carbonsäure,

b) ein wasserunlösliches, in wässrig-alkalischen Lösungen lösliches Phenolharz und

c) eine aromatische Ketoverbindung mit mindestens einer phenolischen Hydroxygruppe

enthält.

Das erfindungsgemässe Gemisch ist dadurch gekennzeichnet, dass die aromatische Ketoverbindung ein Kondensationsprodukt aus einem Hydroxybenzophenon und Formaldehyd ist.

In der DE-OS 2 547 905 sind lichtempfindliche Kopiermaterialien der hier angegebenen Art beschrieben, die unter anderem Polyhydroxybenzophenone enthalten. Diese Verbindungen sind nicht mit Formaldehyd kondensiert; sie werden zur Verbesserung der Schichthaftung auf dem Träger zugesetzt. Von einer Erhöhung der Lichtempfindlichkeit ist in diesem Zusammenhang nicht die Rede.

Die in den erfindungsgemässen Gemischen und den daraus gebildeten Kopierschichten enthaltenen aromatischen Ketoverbindungen sind Polykondensationsprodukte aus Hydroxybenzophenoneinheiten über Methylenbrücken miteinander verbunden sind. Dabei soll mindestens eine OH-Gruppe dem C-Atom, das die Carbonylgruppe trägt, benachbart sein. Die bevorzugten Kondensationsprodukte können durch die allgemeine Formel I

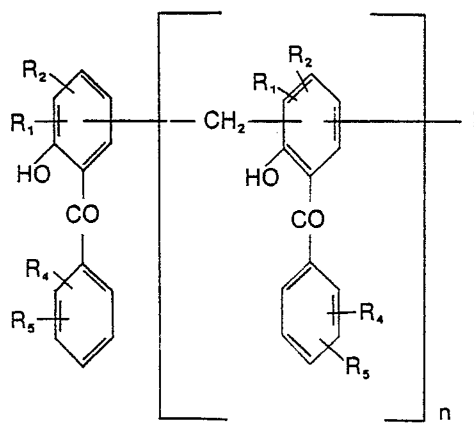

I

wiedergegeben werden, in der

$R_1$, $R_2$, $R_4$ und $R_5$ Wasserstoffatome oder OH-Gruppen,

n eine Zahl von 1 bis 10

bedeuten.

Die Benzophenoneinheiten können, wie sich aus der Herstellung ergibt, gegebenenfalls auch über zwei Methylenbrücken miteinander verbunden sein.

Zur Umsetzung mit Formaldehyd geeignete Hydroxybenzophenone sind solche, die mindestens eine freie o- oder p-Stellung in einem Phenolkern aufweisen. Beispiele für Hydroxybenzophenone, die sich nach Kondensation mit Formaldehyd als Zusatz für das erfindungsgemässe Gemisch besonders gut eignen, sind:

2,3,4-Trihydroxy-benzophenon,

2,4-Dihydroxy-benzophenon,

2,4,6-Trihydroxy-benzophenon,
2,3,4,4'-Tetrahydroxy-benzophenon,
2,2',4,4'-Tetrahydroxy-benzophenon,
2,4,4'-Trihydroxy-benzophenon.

Hydroxybenzophenone mit mindestens 2 OH-Gruppen im Molekül werden im allgemeinen bevorzugt.

Die oben genannten Hydroxy-benzophenone werden mit wässriger Formaldehyd-Lösung (38 Gew.-%) im allgemeinen in einer Menge von 1 bis 1,5 Mol je Mol phenolischer Verbindung, zweckmässig in Gegenwart eines sauren Katalysators, umgesetzt. Die Verbindungen werden entweder ohne weitere Zusätze oder in organischen Lösungsmitteln miteinander kondensiert. Als organische Lösungsmittel für die Polykondensation sind z.B. Methyläthylketon, Tetrahydrofuran und insbesondere 1,4-Dioxan geeignet.

Als saure Katalysatoren eignen sich z.B. Salzsäure, Oxalsäure oder p-Toluolsulfonsäure.

Zur Polykondensation wird das Reaktionsgemisch einige Zeit, z.B. eine Stunde auf 70–100 °C erwärmt. Im allgemeinen fällt das Kondensationsprodukt aus der Reaktionslösung aus, andernfalls wird das relativ dünnflüssige Gemisch unter Rühren in eine überschüssige Menge Eiswasser langsam eingegossen und wie üblich aufgearbeitet.

Bei der Kondensation, die weitgehend analog zur Herstellung der Phenol-Formaldehydharze verläuft, werden in der Regel polymerhomologe Gemische von Polykondensationsprodukten gebildet. Wenn phenolische Ausgangsprodukte verwendet werden, die nur eine kondensationsfähige Kernposition, also nur eine unbesetzte o- oder p-Stellung zu einer OH-Gruppe, aufweisen, so werden in der Regel die reinen Umsetzungsprodukte mit 2 durch eine Methylengruppe verbundenen Hydroxybenzophenoneinheiten gebildet.

Die Konzentration der Hydroxybenzophenon-Kondensationsprodukte in dem lichtempfindlichen Gemisch kann in relativ weiten Grenzen schwanken. Sie liegt im allgemeinen zwischen 4 und 20 Gew.-%, vorzugsweise zwischen 6 und 10 Gew.-%, bezogen auf die Gesamtfeststoffanteile des Gemisches bzw. der Kopierschicht.

Als 1,2-Naphthochinondiazidverbindungen werden die Sulfonsäurederivate, insbesondere die Ester mit aromatischen Hydroxyverbindungen bevorzugt. Die Sulfonsäuregruppe steht im allgemeinen in der 4- oder 5-Stellung des Naphthalinkerns, die 5-Sulfonsäurederivate werden bevorzugt. Geeignete Naphthochinondiazide sind bekannt und z.B. in den DE-PS 938 233, 1 124 817, 1 109 521, 1 120 273, 1 114 705 und 1 543 721 sowie in den älteren deutschen Patentanmeldungen P 2 742 631 und P 2 828 037 beschrieben. Die Menge der Naphthochinondiazidverbindungen in dem Gemisch liegt im allgemeinen zwischen 10 und 30, vorzugsweise zwischen 15 und 25 Gew.-%, bezogen auf den Gehalt an Feststoffen bzw. an nichtflüchtigen Bestandteilen.

Die in dem erfindungsgemässen Gemisch enthaltenen, nicht strahlungsempfindlichen, wasserunlöslichen, alkalilöslichen, filmbildenden Phenolharze haben ein Molekulargewicht von etwa 300 bis 5000 und werden durch Kondensation von Phenol oder substituierten Phenolen mit Formaldehyd hergestellt. Geeignete substituierte Phenole sind Kresol, Xylenol, Butylphenol und ähnliche. Die besonders bevorzugten alkalilöslichen filmbildenden Phenolharze sind Phenol/Formaldehyd-Novolake, Kresol/Formaldehyd-Novolake und phenolmodifizierte Xylenol/Formaldehyd-Novolake. Die Menge des Phenolharzes liegt im Bereich von etwa 50 bis 90 Gew.-%, bevorzugt 65 bis 85 Gew.-% der gesamten nichtflüchtigen Bestandteile.

Die erfindungsgemässen Gemische können in an sich bekannter Weise noch Füllstoffe, Farbstoffe, Pigmente, photolytische Säurebildner, z.B. 1,2-Naphthochinon-(2)-4-sulfonsäurechlorid, und andere übliche Zusatz- und Hilfsstoffe enthalten.

Als Kopierschichtträger können die in der Reproduktionstechnik üblichen verwendet werden, das sind z.B. Platten oder Folien aus Metall, wie Aluminium oder Zink, mit entsprechend vorbehandelter Oberfläche, Mehrmetallplatten, z.B. aus Chrom/Messing, Chrom/Kupfer/Aluminium, Chrom/Kupfer/Zink, ferner Papierfolien, Kunststoff-Folien, für den Siebdruck geeignete Gewebe oder metallisierte Isolierstoffplatten. Bevorzugt werden Aluminiumbleche mit entsprechender Vorbehandlung zur Verbesserung der Haftung der Kopierschicht und zur Verbesserung der Hydrophilie der Schichtträgeroberfläche, beispielsweise mechanisch oder elektrochemisch aufgerauhte und ggf. anodisierte oder chemisch vorbehandelte Al-Bleche.

Die Beschichtung des Trägermaterials erfolgt in an sich bekannter Weise, z.B. durch Antrag mittels Walzen oder Wannen, durch Aufsprühen oder Begiessen. Ein geeigneter Bereich des Schichtgewichtes auf Trockenbasis liegt zwischen 1,0 und 3,0 $g/m^2$. Niedrigere Überzugsmengen begünstigen zwar die photographische Empfindlichkeit, haben aber den Nachteil einer verringerten Filmfestigkeit und einer verringerten Druckauflagenhöhe.

Die lichtempfindlichen Kopiermaterialien werden nach der Belichtung in üblicher Weise mit wässrig-alkalischen Lösungen, die auch kleinere Mengen organischer Lösungs- oder Netzmittel enthalten können, entwickelt. Die Entwicklung kann durch Tauchen, Bürsten, Sprühen in geeigneten Verarbeitungsgeräten oder manuell durch Überwischen oder Reiben mit einem Tampon erfolgen.

Durch die Erfindung wird eine deutliche Erhöhung der Lichtempfindlichkeit gegenüber den bekannten positiv arbeitenden Kopierschichten erreicht, ohne dass zugleich in bemerkenswerter Weise kopier- und drucktechnische Nachteile, d.h. Verschlechterung der Entwicklerresistenz der Kopierschicht, der Gradation, des Bildkontrastes oder der Druckauflagenhöhe, in Kauf genommen werden müssen.

Die Erfindung wird im einzelnen anhand der nachfolgenden Beispiele erläutert.

Beispiel 1

Man löst

0,73 Gt des Veresterungsproduktes aus einem Mol 2,3,4-Trihydroxy-benzophenon und 3 Mol Naphthochinon-(1,2)-diazid-(2)-5-sulfonsäurechlorid,

0,55 Gt des Veresterungsproduktes aus einem Mol 2,2'-Dihydroxy-dinaphthyl-(1,1')-methan und 2 Mol Naphthochinon-(1,2)-diazid-(2)-5-sulfonsäurechlorid,

5,33 Gt eines Kresol-Formaldehyd-Novolaks mit einem Erweichungspunkt von 105–120 °C nach Kapillarmethode DIN 53 181,

0,17 Gt Naphthochinon-(1,2)-diazid-(2)-4-sulfonsäurechlorid,

0,06 Gt Kristallviolett (C.I. 42 555) und

0,68 Gt des unten beschriebenen Kondensationsproduktes aus 2,3,4-Trihydroxy-benzophenon und Formaldehyd

in einem Lösungsmittelgemisch aus

40 Gt Äthylenglykolmonomethyläther,

50 Gt Tetrahydrofuran und

10 Gt Butylacetat.

Mit dieser Lösung beschichtet man eine elektrochemisch aufgerauhte und anodisierte Aluminium-Folie. Das Schichtgewicht der Trockensubstanz beträgt hierbei 2,3 g/m².

Zur Herstellung einer Druckform wird die so erhaltene Druckplatte unter einem Diapositiv belichtet und in bekannter Weise mit der folgenden Lösung

5,3 Gt Natriummetasilikat · 9 $H_2O$,

3,4 Gt Trinatriumorthophosphat · 12 $H_2O$,

0,3 Gt Natriumdihydrogenphosphat (wasserfrei),

91 Gt Wasser

entwickelt, wobei die belichteten Schichtbereiche entfernt werden. Von der so hergestellten Druckform können in einer Offsetmaschine etwa 150 000 einwandfreie Drucke hergestellt werden.

Die wie oben beschrieben hergestellte lichtempfindliche lithographische Druckplatte wurde unter einem Belichtungstestkeil mit Hilfe einer Metall-Halogenid-Lampe von 5000 Watt bei einem Lampenabstand von 103 cm 25 Sekunden lang belichtet. Die optimale Belichtungszeit wurde als der Wert ermittelt, bei dem die Stufe 10 des hier verwendeten Halbtonstufenkeils voll gedeckt auf der Platte steht. Die Dichtewerte des verwendeten Belichtungstestkeils sind aufeinanderfolgend um jeweils 0,15 abgestuft. Die höchste Dichte beträgt 1,95 bei der Stufe 13.

Wird eine gleiche Druckform, jedoch ohne Zusatz des Kondensationsproduktes aus 2,3,4-Trihydroxy-benzophenon und Formaldehyd, bei gleicher Schichtdicke und auf dem gleichen Trägermaterial und bei sonst gleichen Versuchsbedingungen hergestellt, so beträgt die Belichtungszeit, bei der die Stufe 10 des verwendeten Belichtungskeils auf der entwickelten Druckform voll gedeckt ist, 44 Sekunden. Durch den Zusatz des 2,3,4-Trihydroxy-benzophenon / Formaldehyd - Kondensationsproduktes zu der Kopierschicht konnte die Lichtempfindlichkeit somit um 76% gesteigert werden.

Ein weiterer wesentlicher Vorteil der Erfindung ist, dass durch den Zusatz weder die Druckauflagenhöhe noch das drucktechnische Verhalten während des Fortdruckes, z.B. die Wasserführung, noch die übrigen kopiertechnischen Eigenschaften, wie Gradation, Bildkontrast und vor allem die Resistenz der Druckschablone gegenüber alkalischem Entwickler, nachteilig beeinflusst werden.

Die Herstellung der Hydroxybenzophenon/Formaldehyd-Kondensationsprodukte erfolgt analog zur Herstellung der Phenol/Formaldehyd-Novolake. Das niedermolekulare Reaktionsprodukt aus 2,3,4-Trihydroxy-benzophenon und Formaldehyd, wie es im Beispiel 1 eingesetzt wurde, wird relativ leicht durch Erhitzen einer Lösung von 2,3,4-Trihydroxy-benzophenon in überschüssiger Formaldehydlösung (38 Gew.-%) auf 80–100 °C in Gegenwart von 1n Salzsäure erhalten.

Das Kondensationsprodukt, das aus zwei über eine Methylenbrücke miteinander verbundenen Hydroxybenzophenon-Resten besteht, fällt nach relativ kurzer Zeit in reiner Form aus der Reaktionslösung aus. Aus Methanol umkristallisiert, schmilzt dieses Kondensationsprodukt bei 223 °C.

In den folgenden Beispielen werden hinsichtlich Erhöhung der Lichtempfindlichkeit ähnliche Resultate erhalten wie im Beispiel 1. Die gefundenen kürzeren Belichtungszeiten werden jeweils im Vergleich zu den entsprechenden Kopierschichten ohne Zusatz der Hydroxybenzophenon/Formaldehyd-Kondensationsprodukte angegeben.

Alle vergleichenden Untersuchungen wurden jeweils unter gleichen Versuchsbedingungen wie im Beispiel 1 durchgeführt. Die absoluten Belichtungszeiten können naturgemäss je nach Lampentyp und Lampenabstand abweichen. Entsprechend wie im Beispiel 1 werden auch bei den folgenden Beispielen trotz kürzerer Belichtungszeiten keine drucktechnischen und kopiertechnischen Nachteile der Druckplatte festgestellt. Von allen Beispielen können Auflagen von mindestens 100 000 Drucken hergestellt werden.

Beispiel 2

Man löst

0,880 Gt 4-(α,α-Dimethyl-benzyl)-phenylester der Naphthochinon-(1,2)-diazid-(2)-4-sulfonsäure,

0,437 Gt des Veresterungsproduktes aus einem Mol 2,2'-Dihydroxy-dinaphthyl-(1,1')-methan und 2 Mol Naphthochinon-(1,2)-diazid-(2)-5-sulfonsäurechlorid,

5,300 Gt des in Beispiel 1 angegebenen Novolaks,

0,200 Gt Naphtochinon-(1,2)-diazid-(2)-4-sulfonsäurechlorid,

0,640 Gt des Polykondensationsproduktes aus 2,3,4,4'-Tetrahydroxy-benzophenon und Formaldehyd und

0,062 Gt Kristallviolett

in einem Lösungsmittelgemisch aus

40 Gt Äthylenglykolmonomethyläther,

40 Gt Tetrahydrofuran und

8 Gt Butylacetat.

Mit dieser Lösung wird eine elektrochemisch aufgerauhte und anodisierte Aluminium-Folie beschichtet.

Belichtungszeit: 29 Sekunden.
Ohne Zusatz des Hydroxybenzophenon/Formaldehyd-Kondensationsproduktes resultiert eine Belichtungszeit von 44 Sekunden.

Das Kondensationsprodukt aus 2,3,4,4′-Tetrahydroxybenzophenon und Formaldehyd wird analog wie in Beispiel 1 beschrieben durch Umsetzen der Phenolkomponente mit einem Überschuss Formaldehyd hergestellt. Das Reaktionsprodukt ist ein harzartiges Gemisch von Homologen mit unterschiedlichem Kondensationsgrad.

Beispiel 3

Man löst

1,40 Gt des Veresterungsproduktes aus einem Mol 2,4-Dihydroxy-3,5-dibrom-benzophenon und 2 Mol Naphthochinon-(1,2)-diazid-(2)-5-sulfonsäurechlorid,
5,32 Gt des in Beispiel 1 angegebenen Novolaks,
0,06 Gt Kristallviolett,
0,18 Gt Naphthochinon-(1,2)-diazid-(2)-4-sulfonsäurechlorid und
0,56 Gt des Polykondensationsproduktes aus 2,4,4′-Trihydroxy-benzophenon und Formaldehyd

in einem Lösungsmittelgemisch aus

40 Gt Äthylenglykolmonomethyläther,
50 Gt Tetrahydrofuran und
8 Gt Butylacetat.

Mit dieser Lösung beschichtet man ein elektrochemisch aufgerauhtes und anodisiertes Aluminium-Blech.

Belichtungszeit: 24 Sekunden.
Ohne Zusatz des Benzophenon/Formaldehyd-Kondensationsproduktes resultiert eine Belichtungszeit von 35 Sekunden.

Beispiel 4

Man löst

1,26 Gt des Veresterungsproduktes aus einem Mol 2,3,4-Trihydroxy-benzophenon und 2 Mol Naphthochinon-(1,2)-diazid-(2)-5-sulfonsäurechlorid,
0,700 Gt des Veresterungsproduktes aus 2,2′-Dihydroxy-dinaphthyl-(1,1′)-methan und 2 Mol Naphthochinon-(1,2)-diazid-(2)-5-sulfonsäurechlorid,
4,905 Gt des in Beispiel 1 angegebenen Novolaks,
0,055 Gt Sudangelb GGN (C.I. 11 021) und
0,600 Gt des Polykondensationsproduktes aus 2,4-Dihydroxy-benzophenon und Formaldehyd

in einem Lösungsmittelgemisch aus

40 Gt Äthylenglykolmonomethyläther,
50 Gt Tetrahydrofuran und
8 Gt Butylacetat.

Mit dieser Lösung wird eine elektrochemisch aufgerauhte und anodisierte Aluminium-Folie beschichtet.

Belichtungszeit: 21 Sekunden.

Ohne den Zusatz des Dihydroxy-benzophenon/Formaldehyd-Kondensationsproduktes resultiert eine Belichtungszeit von 35 Sekunden.

Beispiel 5

Man löst

0,760 Gt des Veresterungsproduktes aus einem Mol 2,3,4-Trihydroxy-benzophenon und 3 Mol Naphthochinon-(1,2)-diazid-(2)-5-sulfonsäurechlorid,
0,640 Gt des Veresterungsproduktes aus 2,2′-Dihydroxy-dinaphthyl-(1,1′)-methan und 2 Mol Naphthochinon-(1,2)-diazid-(2)-5-sulfonsäurechlorid,
4,750 Gt eines Phenol/Formaldehyd-Novolaks vom Erweichungspunkt von 112–118 °C (Gehalt an phenolischen Gruppen 14 Gew.-%),
0,155 Gt Polyvinylbutyral,
0,070 Gt Sudangelb GGN (C.I. 11 021),
0,136 Gt Kristallviolett-Base,
0,550 Gt Phosphorsäure-tris-(2-chlor-äthyl)-ester und
0,690 Gt des Kondensationsproduktes aus 2,3,4-Trihydroxy-benzophenon und Formaldehyd

in einem Lösungsmittelgemisch aus

40 Gt Äthylenglykolmonomethyläther,
50 Gt Tetrahydrofuran und
10 Gt Butylacetat.

Mit dieser Lösung wird ein elektrochemisch aufgerauhtes und anodisiertes Aluminium-Blech beschichtet.

Belichtungszeit: 23 Sekunden.
Ohne den Zusatz des Trihydroxy-benzophenon/Formaldehyd-Kondensationsproduktes resultiert eine Belichtungszeit von 35 Sekunden.

Beispiel 6

Man löst

0,893 Gt des Veresterungsproduktes aus einem Mol 2,4-Dihydroxy-benzophenon und 2 Mol Naphthochinon-(1,2)-diazid-(2)-5-sulfonsäurechlorid,
0,446 Gt des Veresterungsproduktes aus 1 Mol 2,2′-Dihydroxy-dinaphthyl-(1,1′)-methan und 2 Mol Naphthochinon-(1,2)-diazid-(2)-5-sulfonsäurechlorid,
5,320 Gt des in Beispiel 1 angegebenen Novolaks,
0,061 Gt Kristallviolett,
0,199 Gt Naphthochinon-(1,2)-diazid-(2)-4-sulfonsäurechlorid und
0,600 Gt des Polykondensationsproduktes aus 2,4,6-Trihydroxy-benzophenon und Formaldehyd

in einem Lösungsmittelgemisch aus

40 Gt Äthylenglykolmonomethyläther,
50 Gt Tetrahydrofuran und
10 Gt Butylacetat.

Mit dieser Lösung beschichtet man elektrochemisch aufgerauhtes und anodisiertes Aluminium-Blech.

Belichtungszeit: 27 Sekunden.
Ohne den Zusatz des Trihydroxy-benzophenon/Formaldehyd-Kondensationsproduktes resultiert eine Belichtungszeit von 35 Sekunden.

Beispiel 7

Man löst

0,871 Gt des Veresterungsproduktes aus einem Mol 2,3,4-Trihydroxy-benzophenon und 2 Mol Naphthochinon-(1,2)-diazid-(2)-5-sulfonsäurechlorid,

0,49 Gt des Veresterungsproduktes aus 2,2'-Dihydroxy-dinaphthyl-(1,1')-methan und 2 Mol Naphthochinon-(1,2)-diazid-(2)-5-sulfonsäurechlorid,

5,44 Gt des in Beispiel 1 angegebenen Novolaks,

0,046 Gt Sudangelb GGN (C.I. 11 021),

0,073 Gt Kristallviolett und

0,600 Gt des Kondensationsproduktes aus 2,3,4-Trihydroxy-benzophenon und Formaldehyd,

in einem Lösungsmittelgemisch aus

35 Gt Äthylenglykolmonomethyläther,

45 Gt Tetrahydrofuran,

8 Gt Butylacetat.

Mit dieser Lösung beschichtet man eine mit Hilfe von Drahtbürsten mechanisch aufgerauhte Aluminium-Folie.

Belichtungszeit: 20 Sekunden.

Ohne den Zusatz des Trihydroxy-benzophenon/Formaldehyd-Kondensationsproduktes resultiert eine Belichtungszeit von 37 Sekunden.

**Patentansprüche**

1. Lichtempfindliches Gemisch, das

a) als lichtempfindliche Verbindung einen Ester oder ein Amid einer 1,2-Naphtochinondiazidsulfon- oder -carbonsäure,

b) ein in wässrig-alkalischen Lösungen lösliches, wasserunlösliches Phenolharz und

c) eine aromatische Ketoverbindung mit mindestens einer phenolischen Hydroxygruppe enthält, dadurch gekennzeichnet, dass die aromatische Ketoverbindung ein Kondensationsprodukt aus einem Hydroxybenzophenon und Formaldehyd ist.

2. Lichtempfindliches Gemisch nach Anspruch 1, dadurch gekennzeichnet, dass das Kondensationsprodukt der allgemeinen Formel I

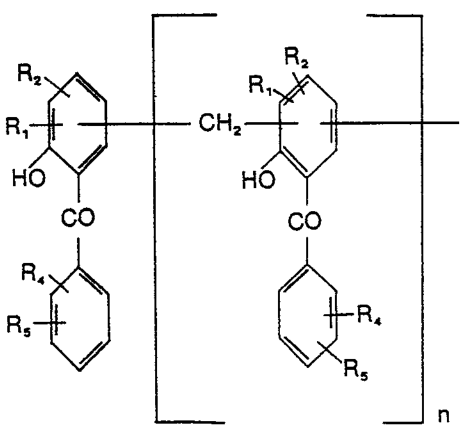

I

entspricht, worin

$R_1$, $R_2$, $R_4$ und $R_5$ Wasserstoffatome oder OH-Gruppen,

n eine Zahl von 1 bis 10

bedeuten.

3. Lichtempfindliches Gemisch nach Anspruch 1, dadurch gekennzeichnet, dass es das Kondensationsprodukt in einer Menge von 3 bis 20 Gew.-%, bezogen auf das Gewicht seiner nichtflüchtigen Bestandteile, enthält.

4. Lichtempfindliches Gemisch nach Anspruch 1, dadurch gekennzeichnet, dass das Hydroxybenzophenon mindestens zwei Hydroxygruppen im Molekül enthält.

5. Lichtempfindliches Gemisch nach Anspruch 4, dadurch gekennzeichnet, dass das Hydroxybenzophenon das 2,3,4-Trihydroxy-benzophenon ist.

6. Lichtempfindliches Kopiermaterial, bestehend aus einem Schichtträger und einer lichtempfindlichen Schicht, die

a) als lichtempfindliche Verbindung einen Ester oder ein Amid einer 1,2-Naphthochinondiazidsulfon- oder -carbonsäure,

b) ein wasserunlösliches, in wässrig-alkalischen Lösungen lösliches Phenolharz und

c) eine aromatische Ketoverbindung mit mindestens einer phenolischen Hydroxygruppe enthält, dadurch gekennzeichnet, dass die aromatische Ketoverbindung ein Kondensationsprodukt aus einem Hydroxybenzophenon und Formaldehyd ist.

**Claims**

1. A light-sensitive mixture, which contains

a) an ester or amide of a 1,2-naphthoquinonediazidesulfonic or -carboxylic acid as the light-sensitive compound,

b) a phenolic resin which is soluble in aqueous-alkaline solutions and insoluble in water, and

c) an aromatic keto compound having at least one phenolic hydroxyl group,

characterized in that the aromatic keto compound is a condensation product of a hydroxybenzophenone and formaldehyde.

2. A light-sensitive mixture as claimed in claim 1, wherein the condensation product corresponds to the general formula I

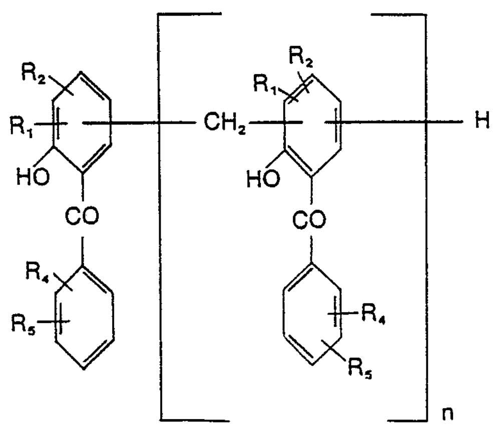

I

in which

$R_1$, $R_2$, $R_4$ and $R_5$ denote hydrogen atoms or OH groups and

n denotes a number from 1 to 10.

3. A light-sensitive mixture as claimed in claim 1, wherein the condensation product is present in a quantity from 3 to 20% by weight, relative to the weight of its non-volatile constituents.

4. A light-sensitive mixture as claimed in claim 1, wherein the hydroxybenzophenone contains at least two hydroxyl groups in the molecule.

5. A light-sensitive mixture as claimed in claim 4, wherein the hydroxybenzophenone is 2,3,4-trihydroxybenzophenone.

6. A light-sensitive copying material, consisting of a support and a light-sensitive layer which contains

a) an ester or amide of a 1,2-naphthoquinonediazidesulfonic or -carboxylic acid as the light-sensitive compound,

b) a phenolic resin which is insoluble in water and soluble in aqueous-alkaline solutions and

c) an aromatic keto compound having at least one phenolic hydroxyl group,
characterized in that the aromatic keto compound is a condensation product of a hydroxybenzophenone and formaldehyde.

**Revendications**

1. Composition photosensible contenant:

a) en tant que composé photosensible un ester ou un amide d'un acide 1,2-naphthoquinone-diazidesulfonique ou 1,2-naphthoquinone-diazide-carboxylique,

b) une résine phénolique soluble dans des solutions aqueuses alcalines, insoluble dans l'eau, et

c) un composé cétonique aromatique renfermant au moins un groupe hydroxyle phénolique, caractérisée en ce que le composé cétonique est un produit de condensation à partir d'une hydroxy-benzophénone et de formaldéhyde.

2. Composition photosensible selon la revendication 1, caractérisée en ce que le produit de condensation répond à formule générale I

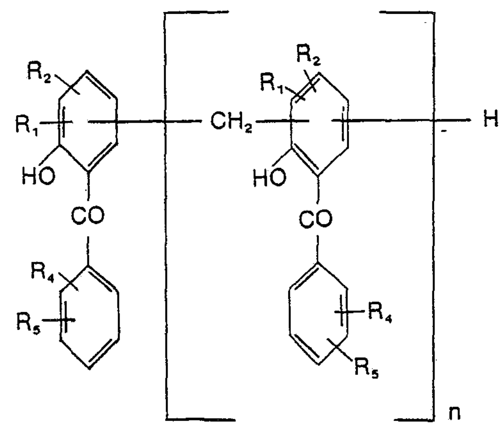

I

dans laquelle:

$R_1$, $R_2$, $R_4$, et $R_5$ sont des atomes d'hydrogène ou des groupes-OH,

n est un nombre de 1 à 10.

3. Composition photosensible selon la revendication 1, caractérisée en ce qu'il contient le produit de condensation en une quantité de 3 à 20% en poids par rapport au poids de ses ingrédients non volatils.

4. Composition photosensible selon la revendication 1, caractérisée en ce que l'hydroxy-benzophénone comporte au moins deux groupes hydroxyle dans sa molécule.

5. Composition photosensible selon la revendication 4, caractérisée en ce que l'hydroxy-benzophénone est la 2,3,4-trihydroxy-benzophénone.

6. Matériel photosensible pour la reproduction, composé d'un support de couche et d'une couche photosensible, comprenant:

a) en tant que composé photosensible un ester ou un amide d'un acide 1,2-naphthoquinonediazidesulfonique ou 1,2-naphthoquinonediazide carboxylique,

b) une résine phénolique insoluble dans l'eau et soluble dans des solutions aqueuses alcalines, et

c) un composé cétonique aromatique renfermant au moins un groupe hydroxyle phénolique, caractérisé en ce que le composé cétonique aromatique est un produit de condensation à partir d'une hydroxybenzophénone et de formaldéhyde.